# EUROPEAN PATENT APPLICATION

(11) **EP 4 485 526 A1**
(43) Date of publication of application: **01.01.2025**
(21) Application number: 23759625.9
(22) Date of filing: 02.02.2023
(51) Int. Cl.: H01L 23/36, B32B 7/027, B32B 18/00, H01L 23/12, H01L 23/13, H01L 23/15, H05K 1/03

(54) **HEAT-CONDUCTIVE LAYERED INSULATING SUBSTRATE**

(30) Priority: 22.02.2022 JP 2022025356
(71) Applicant: SHIN-ETSU CHEMICAL CO., LTD., Tokyo 1000005 (JP)
(72) Inventor: MOGI Hiroshi, Annaka-shi, Gunma 379-0224 (JP); UCHIDA Osamu, Annaka-shi, Gunma 379-0224 (JP); YAGINUMA Atsushi, Annaka-shi, Gunma 379-0224 (JP); MOTEKI Masaki, Tokyo 100-0005 (JP)
(74) Representative: Sonnenhauser, Thomas Martin
(86) International application number: PCT/JP2023/003463
(87) International publication number: WO 2023/162619

(57) **Abstract**

The present invention is a thermal conductive stacked insulative substrate including: an elastic layer; and a thermal conductive ceramics insulative substrate, wherein the elastic layer is directly stacked on a surface of the thermal conductive ceramics insulative substrate. This provides a thermal conductive stacked insulative substrate having a small thermal resistivity and excellent thermal conductivity.

## Description

### TECHNICAL FIELD

The present invention relates to a thermal conductive stacked insulative substrate.

### BACKGROUND ART

Control systems for automobiles, aircrafts, watercrafts, or electronic devices for home-use or business-use have become more precise and more complex, and an integration density of microelectronic components on a circuit substrate has continued to increase therewith. As a result, it has been strongly desired to solve defects or shortening of lifetime of the electronic components due to heat generation around the circuit substrate. To achieve quick heat dissipation from the circuit substrate, a method in which the circuit substrate itself is composed of a material having excellent heat-dissipating ability has been conventionally known.

Meanwhile, a ceramics substrate itself composed of diamond, aluminum nitride (AlN), silicon nitride (Si₃N₄), etc., which has a high thermal conductance, cannot follow stress on a contact interface with the electronic component etc. due to its hardness. Accordingly, a contact thermal resistance becomes high to fail to utilize the high heat-dissipating ability of the ceramics.

As a stress buffer layer, proposed is a stacked circuit substrate in which a silicone rubber sheet adheres to a metal substrate or a ceramics substrate by using an adhesive (Patent Document 1). The ceramics substrate in which the silicone rubber sheet is stacked via the adhesive, however, has problems of failure to obtain stable adhesiveness and occurrence of defects with peeling of the silicone rubber sheet due to floating or expansion in pressing to increase the thermal resistance.

### CITATION LIST

### PATENT LITERATURE

Patent Document 1: JP S63-246895 A

### SUMMARY OF INVENTION

### TECHNICAL PROBLEM

In the conventional art, the ceramics substrate in which the silicone rubber sheet is stacked via the adhesive has problems of failure to obtain stable adhesiveness and occurrence of defects with peeling of the silicone rubber sheet due to floating or expansion in pressing to increase the thermal resistance.

The present invention has been made in view of the above circumstances. An object of the present invention is to provide a thermal conductive stacked insulative substrate having a small thermal resistivity and excellent thermal conductivity.

### SOLUTION TO PROBLEM

To solve the above problems, the present invention provides a thermal conductive stacked insulative substrate comprising:
an elastic layer; and
a thermal conductive ceramics insulative substrate,
wherein the elastic layer is directly stacked on a surface of the thermal conductive ceramics insulative substrate.

Such a thermal conductive stacked insulative substrate can provide the thermal conductive stacked insulative substrate having a small thermal resistivity and excellent thermal conductivity.

The thermal conductive ceramics insulative substrate is preferably composed of: one or more thermal conductive powders selected from a metal oxide and a metal nitride; and a sintered product of a slurry containing a binder resin.

The thermal conductive stacked insulative substrate having such a thermal conductive ceramics insulative substrate can provide the thermal conductive stacked insulative substrate having a higher thermal conductance.

The thermal conductive powder preferably comprises one or more of an alumina powder, an aluminum nitride powder, and a silicon nitride powder.

The thermal conductive stacked insulative substrate having such a thermal conductive ceramics insulative substrate can provide the thermal conductive stacked insulative substrate having a higher thermal conductance.

The slurry preferably further comprises one or more of silica, magnesia, and yttrium oxide as a sintering auxiliary.

The thermal conductive stacked insulative substrate having such a thermal conductive ceramics insulative substrate sintered by using such a sintering auxiliary can provide the thermal conductive stacked insulative substrate having a higher thermal conductance.

The elastic layer is preferably a cured product of a liquid silicone rubber composition.

The thermal conductive stacked insulative substrate having such an elastic layer has preferable elastic deformation ability, and thereby can efficiently conduct heat.

### ADVANTAGEOUS EFFECTS OF INVENTION

As noted above, the thermal conductive stacked insulative substrate of the present invention has a small thermal resistivity, inhibited contact thermal resistance, and excellent thermal conductivity, and thereby can provide the thermal conductive stacked insulative substrate that can quickly conduct heat generation from the electronic components to the thermal conductive stacked insulative substrate to dissipate the heat.

### BRIEF DESCRIPTION OF DRAWING

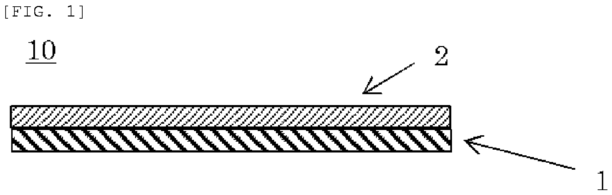

FIG. 1 is a vertical sectional view of the thermal conductive stacked insulative substrate of the present invention.

### DESCRIPTION OF EMBODIMENTS

As noted above, there has been a demand for development of the thermal conductive stacked insulative substrate having a small thermal resistivity and excellent thermal conductivity.

The present inventors have made earnest study to solve the above problem, and consequently found that the following thermal conductive stacked insulative substrate can achieve the above object, and allow the substrate to be suitable as the circuit substrate. This finding has led to completion of the present invention.

Specifically, the present invention is a thermal conductive stacked insulative substrate, comprising:
an elastic layer; and
a thermal conductive ceramics insulative substrate,
wherein the elastic layer is directly stacked on a surface of the thermal conductive ceramics insulative substrate.

Hereinafter, the present invention will be described in detail, but the present invention is not limited thereto.

### Thermal Conductive Stacked Insulative Substrate

As illustrated in FIG. 1, a thermal conductive stacked insulative substrate 10 of the present invention comprises an elastic layer 2 and a thermal conductive ceramics insulative substrate 1, wherein the elastic layer 2 is directly stacked on a surface of the thermal conductive ceramics insulative substrate 1. That is, the thermal conductive stacked insulative substrate 10 of the present invention has no adhesive layer between the thermal conductive ceramics insulative substrate 1 and the elastic layer 2.

### Thermal Conductive Ceramics Insulative Substrate

As the thermal conductive ceramics insulative substrate, a material composed of: one or more thermal conductive powders selected from a metal oxide and a metal nitride; and a sintered product of a slurry containing a binder resin may be used.

The thermal conductive powder is not particularly limited as long as it has electric insulability and exhibits thermal conductivity. The thermal conductive powder is preferably a metal oxide, a metal nitride, etc., and more preferably an alumina powder, an aluminum nitride powder, and a silicon nitride powder.

The binder resin is not particularly limited. The binder resin is preferably a butyral resin, and a commercially available product such as S-LEC B, manufactured by SEKISUI CHEMICAL CO., LTD., may also be used, for example.

The slurry may further contain an sintering auxiliary in order to promote sintering for stabilization. As the sintering auxiliary, silica, magnesia, yttrium oxide, etc. may be preferably used.

The slurry may contain a solvent, a plasticizer, a dispersing agent, etc. in addition to the above components. The solvent is preferably an alcohol such as ethanol and isopropyl alcohol. As the plasticizer, dioctyl phthalate, dibutyl phthalate, etc. may be used.

### Method for Manufacturing Thermal Conductive Ceramics Insulative Substrate

The thermal conductive ceramics insulative substrate can be manufactured by, for example: mixing the thermal conductive powder, the binder resin, and as necessary the sintering auxiliary, the solvent, and other components in a ball mill pot; forming the obtained slurry into a sheet by a doctor blade method; cutting the sheet to a predetermined size; and via a defatting step and a sintering step.

The defatting step is preferably performed by heating at 100 to 800°C. The sintering step is preferably performed at a temperature of 1,500 to 2,000°C under an inert gas atmosphere such as nitrogen.

The thermal conductance of the thermal conductive ceramics insulative substrate is preferably 100 W/m·k or more, and more preferably 150 W/m·k or more. An upper limit of the thermal conductance is not particularly limited, but typically approximately 500 W/m·k.

### Elastic Layer

In the thermal conductive stacked insulative substrate of the present invention, the elastic layer is directly stacked on the surface of the thermal conductive ceramics insulative substrate via no adhesive etc.

As the elastic layer, an elastic material such as silicone rubber, ethylene-propylene rubber, fluororubber, acryl rubber, and styrene-butadiene rubber may be used, for example. Among these, a cured product of a liquid silicone rubber composition is preferably used.

As the liquid silicone rubber composition, a self-adhesion type addition-curable liquid silicone rubber is preferable in terms of no byproduct in curing and curing in a short time.

The liquid silicone rubber composition preferably has a thermal conductance of 1.0 W/m·k or more, and more preferably 3.0 W/m-k or more. Such a liquid silicone rubber composition is not particularly limited, and examples thereof include a composition containing a thermal conductive filler such as aluminum nitride. Such a composition can more easily conduct heat generated from electronic components etc. via the elastic layer.

A method for stacking the elastic layer on the surface of the thermal conductive ceramics insulative substrate may be coating by screen printing and curing the liquid silicone rubber composition on the surface of the thermal conductive ceramics insulative substrate. This method can directly form the elastic layer without an adhesive etc.

The liquid silicone rubber composition may be cured under a known condition. The condition is not particularly limited, and as an example for the addition-curable silicone rubber composition, the curing can be performed under conditions at 100 to 180°C for 10 minutes to 5 hours.

### EXAMPLE

Hereinafter, the present invention will be specifically described by using Examples and Comparative Examples. However, the present invention is not limited thereto.

A kinematic viscosity is a value at 25°C measured by using a Cannon-Fenske viscosimeter, and a thermal resistivity of the obtained thermal conductive stacked insulative substrate was measured under conditions of 50°C / 100 psi in accordance with ASTM D5470.

### Example 1

Into 100 parts by mass of a mixture composed of 97 mass% of aluminum nitride powder and 3 mass% of yttrium oxide powder, 10 parts by mass of a butyral resin (S-LEC B, manufactured by SEKISUI CHEMICAL CO., LTD.), 60 parts by mass of ethanol, and 12 parts by mass of dioctyl phthalate were added, and then the mixture was kneaded in a ball mill for 50 hours to produce a slurry.

Then, the obtained slurry was treated with a vacuum deaerator to partially scattering the solvent to prepare a slurry having a kinematic viscosity of 30,000 mm²/s, and a green sheet having a thickness of 0.7 mm was produced from the slurry by using a doctor blade. This green sheet was cut to 100 × 100 mm, subjected to a defatting treatment in the atmosphere at 700°C, and subsequently sintered in nitrogen gas at 1,850°C. Both surfaces of the obtained sintered product were polished to produce a thermal conductive ceramics insulative substrate having a thickness of 0.7 mm.

On the surface of the obtained thermal conductive ceramics insulative substrate, a liquid silicone rubber composition (KE1867, manufactured by Shin-Etsu Chemical Co., Ltd., thermal conductance: 2.2 W/m·k) was applied by screen printing, and cured at 150°C to form an elastic layer having a thickness of 0.45 mm (thickness: 0.45 mm). The obtained thermal conductive stacked insulative substrate had a thermal resistivity of 1.5 cm²·k/W.

### Example 2

Into 100 parts by mass of a mixture composed of 96 mass% of aluminum oxide powder, 3 mass% of silica powder, and 1 mass% of magnesia powder, 8 parts by mass of a butyral resin (S-LEC B, manufactured by SEKISUI CHEMICAL CO., LTD.,), 60 parts by mass of ethanol, and 12 parts by mass of dioctyl phthalate were added, and then the mixture was kneaded in a ball mill for 50 hours to produce a slurry.

Then, the obtained slurry was treated with a vacuum deaerator to partially scattering the solvent to prepare a slurry having a kinematic viscosity of 30,000 mm²/s, and a green sheet having a thickness of 0.7 mm was produced from the slurry by using a doctor blade. This green sheet was cut to 100 × 100 mm, subjected to a defatting treatment in the atmosphere at 700°C, and subsequently sintered in nitrogen gas at 1,630°C. Both surfaces of the obtained sintered product were polished to produce a thermal conductive ceramics insulative substrate having a thickness of 0.7 mm.

On the surface of the obtained thermal conductive ceramics insulative substrate, a liquid silicone rubber composition (KE1867, manufactured by Shin-Etsu Chemical Co., Ltd., thermal conductance: 2.2 W/m·k) was applied by screen printing, and cured at 150°C to form an elastic layer having a thickness of 0.45 mm (thickness: 0.45 mm). The obtained thermal conductive stacked insulative substrate had a thermal resistivity of 2.3 cm²·k/W.

### Example 3

Into 100 parts by mass of a mixture composed of 95 mass% of silicon nitride powder and 5 mass% of yttrium oxide powder, 10 parts by mass of a butyral resin (S-LEC B, manufactured by SEKISUI CHEMICAL CO., LTD.,), 60 parts by mass of ethanol, and 12 parts by mass of dioctyl phthalate were added, and then the mixture was kneaded in a ball mill for 50 hours to produce a slurry.

Then, the obtained slurry was treated with a vacuum deaerator to partially scattering the solvent to prepare a slurry having a kinematic viscosity of 30,000 mm²/s, and a green sheet having a thickness of 0.7 mm was produced from the slurry by using a doctor blade. This green sheet was cut to 100 × 100 mm, subjected to a defatting treatment in the atmosphere at 700°C, and subsequently sintered in nitrogen gas at 1,850°C. Both surfaces of the obtained sintered product were polished to produce a thermal conductive ceramics insulative substrate having a thickness of 0.7 mm.

On the surface of the obtained thermal conductive ceramics insulative substrate, a liquid silicone rubber composition (KE1867, manufactured by Shin-Etsu Chemical Co., Ltd., thermal conductance: 2.2 W/m·k) was applied by screen printing, and cured at 150°C to form an elastic layer having a thickness of 0.45 mm (thickness: 0.45 mm). The obtained thermal conductive stacked insulative substrate had a thermal resistivity of 2.0 cm²·k/W.

### Comparative Example 1

On a surface of a thermal conductive ceramics insulative substrate obtained by the same method as in Example 1, a silicone rubber sheet having a thickness of 0.45 mm formed in advance from a silicone rubber composition (TC-45A, manufactured by Shin-Etsu Chemical Co., Ltd., thermal conductance: 0.8 W/m·k) was adhered by using an epoxy resin adhesive to produce a thermal conductive stacked insulative substrate. The obtained thermal conductive stacked insulative substrate had a thermal resistivity of 4.5 cm²·k/W.

The thermal resistivity of the thermal conductive stacked insulative substrate of Comparative Example 1 was 4.5 cm²·k/W. Meanwhile, the thermal conductance in Examples 1 to 3 was 1.5 to 2.3 cm²·k/W, and thereby it has been demonstrated that the thermal conductive stacked insulative substrate of the present invention has a lower thermal resistivity than a thermal conductive stacked insulative substrate using an adhesive. In addition, the lower the thermal resistivity, the higher the thermal conductance, and therefore it has been demonstrated that the thermal conductive stacked insulative substrate of the present invention has excellent thermal conductivity.

From the results, it has been demonstrated that the present invention yields a small thermal resistivity, and therefore yields the thermal conductive stacked insulative substrate with inhibited contact thermal resistance and excellent thermal conductivity compared with the conventional thermal conductive stacked insulative substrate using an adhesive etc.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A thermal conductive stacked insulative substrate, comprising:
an elastic layer; and
a thermal conductive ceramics insulative substrate,
wherein the elastic layer is directly stacked on a surface of the thermal conductive ceramics insulative substrate.

2. The thermal conductive stacked insulative substrate according to claim 1, wherein the thermal conductive ceramics insulative substrate is composed of: one or more thermal conductive powders selected from a metal oxide and a metal nitride; and a sintered product of a slurry containing a binder resin.

3. The thermal conductive stacked insulative substrate according to claim 2, wherein the thermal conductive powder comprises one or more of an alumina powder, an aluminum nitride powder, and a silicon nitride powder.

4. The thermal conductive stacked insulative substrate according to claim 2 or 3, wherein the slurry further comprises one or more of silica, magnesia, and yttrium oxide as a sintering auxiliary.

5. The thermal conductive stacked insulative substrate according to any one of claims 1 to 4, wherein the elastic layer is a cured product of a liquid silicone rubber composition.
